# EUROPEAN PATENT APPLICATION

(11) **EP 1 528 590 A2**
(43) Date of publication of application: **04.05.2005**
(21) Application number: 04025832.9
(22) Date of filing: 29.10.2004
(51) Int. Cl.: H01L 21/20

(54) **Method for producing a nitride semiconductor crystal layer, nitride semiconductor crystal layer and substrate for producing the same**

(30) Priority: 30.10.2003 JP 2003370790
(71) Applicant: Nagoya University Corporation Nagoya University, Nagoya City, Aichi Pref. (JP)
(72) Inventor: Sawaki, Nobuhiko, Nagoya City Aichi Pref. (JP); Honda, Yoshio, Nagoya City Aichi Pref. (JP); Nishimura, Yoshiyuku, Nagoya City Aichi Pref. (JP)
(74) Representative: von Hellfeld, Axel, Dr. Dipl.-Phys.

(57) **Abstract**

A mask with rectangular openings is formed on a large-scaled silicon substrate, and an AlN micro crystalline layer is formed in a thickness of 200nm or over through the mask on the silicon substrate by means of selective and lateral growth. Then, a nitride semiconductor crystal layer with a composition of InxGayAlzN (0≤x, y, z≤1, x+y+z=1) is formed on the AlN micro crystalline layer.

## Description

### BACKGROUND OF THE INVENTION

### Field of the Invention

This invention relates to a method for producing a nitride semiconductor crystal layer, the nitride semiconductor crystal layer and a substrate for producing the nitride semiconductor crystal layer.

### Description of the related art

As of now, in the formation of a compound semiconductor with a composition of InxGayAlzN (0≤x, y, z≤1, x+y+z=1), a substrate made of sapphire (Al₂O₃) or silicon carbide (SiC) is prepared, and the intended compound semiconductor is layered on the substrate by means of epitaxial growth. However, the sapphire substrate (wafer) and the silicon carbide substrate (wafer) are expensive and the large-scaled sapphire substrate and the large-scaled silicon carbide substrate can not be almost available, so that the production cost of the compound semiconductor can not be reduced through the large scale of the substrate to be employed.

In the research and development of a nitride blue laser, a nitride semiconductor crystal is employed as a substrate, and the intended nitride semiconductor is formed by means of homo-epitaxial growth. For example, a substrate made of sapphire or gallium arsenide is employed, and a GaN single crystal layer is grown on the substrate. Thereafter, the GaN single crystal layer is peeled off from the substrate by means of laser irradiation, and applied for the blue laser. In this case, however, the large-scaled substrate can not be almost available and the peeling technique can not be established sufficiently. In order to mitigate the above-mentioned problems, it has been expected that a substrate made of silicon, which can be large-scaled easily, is employed and the GaN single crystal layer is formed on the substrate.

In the crystal growth of a nitride semiconductor on a silicon substrate, in order to compensate the difference in thermal expansion and lattice constant between the silicon substrate and the nitride semiconductor, a method of using an AIN buffer layer or an AlGaN buffer layer has been developed (Honda et al., J. Crystal Growth 230 (2001) 346), so that a nitride semiconductor film with a thickness of about 1 µm can be formed on the silicon substrate and thus, a light-emitting diode can be fabricated using the nitride semiconductor film (T. Egawa, Technical Digest 5th International Conference on Nitride Semiconductors, May, 2003, Nara, ThA8.1). In the fabrication of a laser diode, it is required to develop the crystal quality of the film composing the laser diode. In this point of view, it is also required to thicken the nitride semiconductor film sufficiently. With the above-mentioned conventional technique, however, the thickened nitride semiconductor film can not be formed.

Options of thickening the nitride semiconductor crystal layer on the silicon substrate are to elongate the growth duration and to increase the growth rate. In a MOCVD method, since the growth rate is about 1-2 µm/hour, for example, a growth duration of several hours is required to thicken the nitride semiconductor crystal layer to 5 µm or over. In the formation of the nitride semiconductor crystal layer such as a GaN single crystal layer using a MOCVD method, the silicon substrate must be heated to about 1000°C to grow the nitride semiconductor crystal layer. When the silicon substrate and the nitride semiconductor crystal layer are held under a high temperature, however, the surface of the nitride semiconductor crystal layer may be roughed, so that the intended semiconductor element such as a semiconductor laser can not be fabricated by using the nitride semiconductor crystal layer.

In contrast, the grow rate of the nitride semiconductor crystal layer can be developed by using a HVPE method instead of the MOCVD method. With the HVPE method, a hydrochloric acid gas, which is generated through the chemical dissociation of raw material gases, promotes the chemical reaction between the nitride semiconductor crystal layer and the silicon substrate, but after the growth duration of one hour or over, the surface of the nitride semiconductor crystal layer is roughed and the nitride semiconductor crystal layer itself may be partially destroyed.

On the other hand, since the energy band gap of the nitride semiconductor with the above-mentioned composition is varied widely as the composition is varied, so that it is expected that the nitride semiconductor can be applied for an optical element which can be used within a wide range of infrared light from ultraviolet light. In order to enhance the performance of the optical element and reduce the production cost, it is required to develop the thickening growth technique of the nitride semiconductor crystal layer on the large-scaled silicon substrate, but such a thickening growth technique as mentioned above has not been developed yet.

### SUMMERY OF THE INVENTION

It is an object of the present invention to establish, on a large-scaled silicon substrate, the thickening technique of a nitride semiconductor crystal with a composition of InxGayAlzN (0≤x, y, z≤1, x+y+z=1).

In order to achieve the above object, this invention relates to a method for producing a nitride semiconductor crystal layer, comprising the steps of:
preparing a silicon substrate,
forming an AlN micro crystalline layer in a thickness of 200nm or over on the silicon substrate, and
forming the nitride semiconductor crystal layer with a composition of InxGayAlzN (0≤x, y, z≤1, x+y+z=1) on the AlN micro crystalline layer.

This invention also relates to a substrate for producing a nitride semiconductor crystal layer, comprising:
a silicon substrate, and
an AlN micro crystalline layer with a thickness of 200nm or over which is formed on the silicon substrate.

The inventors had intensely investigate the cause of the surface roughness of a nitride semiconductor crystal layer such as a GaN single crystal layer when the nitride semiconductor crystal layer is formed on a silicon substrate using such a MOCVD method or a HVPE method as mentioned above. First of all, the cross section of the surface roughness area of the nitride semiconductor crystal layer had been investigated in detail by using a transmission electron microscope (TEM), a scanning electron microscope (SEM) and a cathode luminescence spectrum (CL).

As a result, the inventors had found out the following fact of matter: When the silicon substrate and the nitride semiconductor crystal layer is held under a high temperature of about 1000°C, the elemental Si of the silicon substrate is reacted with the elemental Ga of the nitride semiconductor crystal layer slowly to degenerate the surface area of the silicon substrate and to spout the liquid component of the surface area of the silicon substrate, which is generated during the degenerating process, out from minute cracks and pinholes of the nitride semiconductor crystal layer onto the surface thereof repeatedly, so that the surface roughness of the nitride semiconductor crystal layer is caused. In this point of view, the inventors had conceived to provide an AIN intermediate layer not containing Ga between the silicon substrate and the nitride semiconductor crystal layer.

The AlN intermediate layer is located under the nitride semiconductor crystal layer and thus, the nitride semiconductor crystal layer is formed on the AlN intermediate layer. Therefore, the inventors had also conceived that in order to grow the nitride semiconductor crystal layer in good condition and develop the crystal quality thereof, the AlN intermediate layer must be a micro crystalline layer, not an amorphous layer.

As a result, in the present invention, it is required that the AlN micro crystalline layer is formed between the silicon substrate and the nitride semiconductor crystal layer. If the thickness of the AlN micro crystalline layer is small, however, some voids may be created at the boundaries of the micro crystals of the AIN micro crystalline layer. In this case, the elemental Si of the silicon substrate may be reacted with the elemental Ga of the nitride semiconductor crystal layer through the voids, so that the surface roughness of the nitride semiconductor crystal layer may be caused.

In this point of view, the inventors had intensely studied to find out that the voids can not be penetrated through the AlN micro crystalline layer and the chemical reaction between the elemental Si of the silicon substrate and the elemental Ga of the nitride semiconductor crystal layer through the voids can be prevented if the thickness of the AlN micro crystalline layer is set to 200nm or over.

The present invention is established on the above-mentioned consideration. As a result, the nitride semiconductor crystal layer can be formed in a thickness of 5 µm or over, e.g., on the silicon substrate with a diameter of four inches by means of an MOCVD method. If an HVPE method is employed instead of the MOCVD method, the nitride semiconductor crystal layer can be formed in a thickness of 100 µm or over in the same size silicon substrate.

The crystal quality of the AlN micro crystalline layer can be confirmed by means of a TEM or SEM.

In the present invention, the AlN micro crystalline layer can be formed by means of any kind of forming method. Preferably the AlN micro crystalline layer can be formed through a lattice-shaped mask which is provided on the silicon substrate. In this case, the AlN micro crystalline layer is grown in the openings of the mask, embedding the openings and being formed uniformly. According to the forming method using the mask, the lattice distortion and the thermal expansion coefficient difference against the silicon substrate can be compensated, and the selective and lateral growth of the AlN micro crystalline layer can be realized in good condition. As a result, the AlN micro crystalline layer with high crystal quality can be easily formed thicker, e.g., in a thickness of 200nm or over.

The opening configuration of the mask is preferably rectangular, and the side length of the openings of the mask is preferably within 50-500 µm. Moreover, the distance between the adjacent openings, i.e., the opening pitch is preferably within 5-10 µm, and the thickness of the mask is preferably 100nm or below.

The mask can be made of at least one selected from silicon nitride, silicon dioxide and tungsten nitride. In this case, if the mask is held under a temperature and gas atmosphere in the formation of the nitride semiconductor crystal layer and the AlN micro crystalline layer, the mask can not be deteriorated and chemically reacted with the silicon substrate, the AlN micro crystalline layer and the nitride semiconductor crystal layer, so that the intended nitride semiconductor crystal layer can be formed precisely and stably and the crystal quality of the nitride semiconductor crystal layer can be enhanced sufficiently.

As described above, according to the present invention can be provide the thickening technique of a nitride semiconductor crystal with a composition of InxGayAlzN (0≤x, y, z≤1, x+y+z=1) on a large-scaled silicon substrate.

### BRIEF DESCRIPTION OF THE DRAWINGS

For better understanding of the present invention, reference is made to the attached drawings, wherein
Fig. 1 is a step view in a producing method of nitride semiconductor crystal layer according to the present invention,
Fig. 2 is a step view after the step as shown in Fig. 1,
Fig. 3 is a step view after the step as shown in Fig. 2, and
Fig. 4 is a step view after the step as shown in Fig. 3.

### DESCRIPTION OF THE PREFERRED EMBODIMENTS

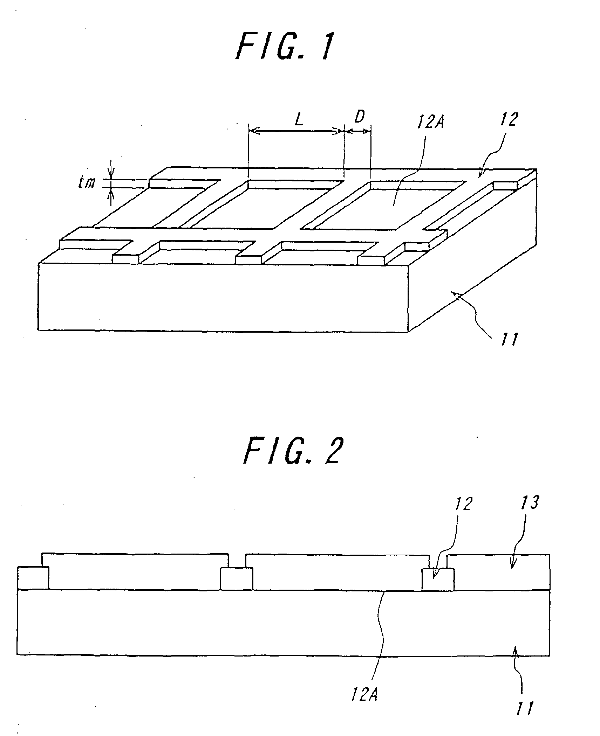

This invention will be described in detail with reference to the accompanying drawings. Figs. 1-4 are step views in a producing method of nitride semiconductor crystal layer according to the present invention. First of all, as shown in Fig. 1, a silicon substrate 11 is prepared, and an underlayer to constitute a mask layer is formed on the silicon substrate 11 by means of a conventional method such as a sputtering method or a CVD method. Then, the underlayer is etched by means of photolithography or electron beam lithography to form openings 12A and thus, complete a mask 12.

The mask 12 is preferably made of at least one selected from silicone nitride, silicon dioxide and tungsten nitride. In this case, if the mask 12 is held later under a temperature and gas atmosphere in the formation of a nitride semiconductor crystal layer and an AlN micro crystalline layer, the mask 12 can not be deteriorated and chemically reacted with the silicon substrate 11, the AlN micro crystalline layer and the nitride semiconductor crystal layer, so that the intended nitride semiconductor crystal layer can be formed precisely and stably and the crystal quality of the nitride semiconductor crystal layer can be enhanced sufficiently.

It is not always required that the mask 12 is made of the above-mentioned material. The mask 12 can be made of any kind of material only if the above-mentioned requirement relating to the mask 12 is satisfied.

The side length L of each opening 12A of the mask 12 is preferably set within 50-500 µm. If each opening 12 A is formed rectangularly, the short side length and the long side length of each opening 12A are preferably set within the above range. The distance D between the adjacent openings 12A, i.e., the pitch of the openings 12A is preferably set within 5-10 µm, and the thickness tm of the mask 12 is preferably set to 100nm or below. In this case, in the ensuing process, the lattice distortion and the thermal expansion against the silicon substrate 11 is compensated, and the selective and lateral growth of the AlN micro crystalline layer to be formed later can be performed in good condition. As a result, the AlN micro crystalline layer can be easily formed thicker, e.g., in a thickness of 200nm or over.

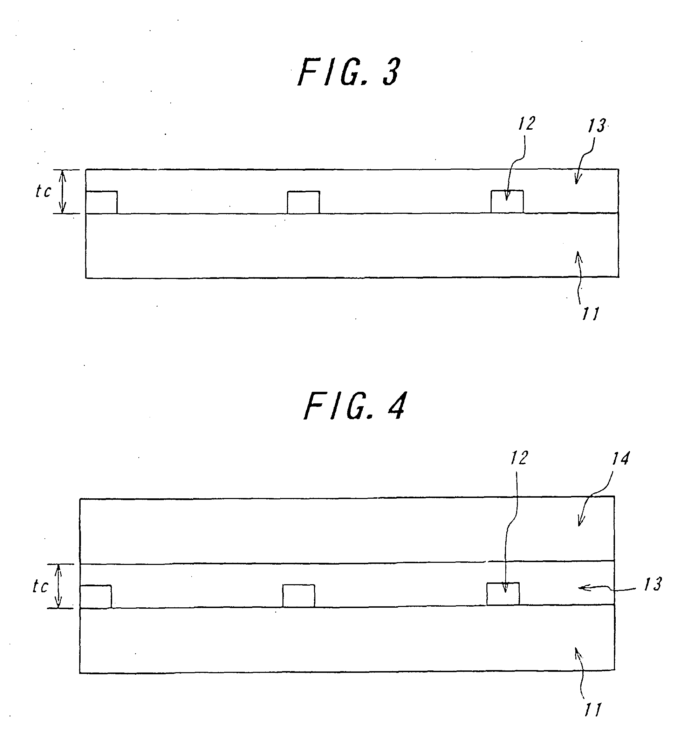

Then, the AlN micro crystalline layer 13 is formed on the silicon substrate 11 through the mask 12. As shown in Fig. 2, the AlN micro crystalline layer 13 is selectively grown in the openings 12A of the mask 12 on the silicon substrate 11 at the initial growth, subsequently embedding the openings 12A and being formed uniformly as shown in Fig. 3. In this embodiment, since the selective and lateral growth using the mask 12 is employed, the lattice distortion and the thermal expansion coefficient difference against the silicon substrate 11 are compensated, and the AlN micro crystalline layer 12 with high crystal quality can be easily formed thicker, e.g., in a thickness of 200nm or over.

In Fig. 3, it is required that the thickness tc of the AlN micro crystalline layer 13 is set to 200nm or over, but preferably set within 200-600nm. If the AlN micro crystalline layer 13 is thicker beyond 600nm, the lattice distortion between the AlN micro crystalline layer 13 and the silicon substrate 11 may be increased to deteriorate the crystal quality of the AlN micro crystalline layer 13.

With an MOCVD method, the AlN micro crystalline layer 13 can be formed by heating the silicon substrate 11 at a temperature within 900-1200°C. The crystal quality of the AlN micro crystalline layer 13 can be confirmed by means of a SEM or TEM.

Then, as shown in Fig. 4, the intended nitride semiconductor crystal layer 14 is formed on the AlN micro crystalline layer 13 by means of a conventional method such as an MOCVD method or an HVPE method. The growth condition can be appropriately selected and determined in dependence on the forming method and the like.

With the MOCVD method, the nitride semiconductor crystal layer 14 can be formed in a thickness of 5 µm or over at a growth rate within 1-3 µm/hour. With the HVPE method, the nitride semiconductor crystal layer 14 can be formed in a thickness of 100 µm or over at a growth rate of 10 µm/hour or over. In both of the MOCVD method and the HVPE method, the nitride semiconductor crystal layer 14 can be formed in the above-ranged thickness on the silicon substrate (wafer) with a diameter of four inches or over.

Generally, the nitride semiconductor crystal layer 14 can have a composition of InxGayAlzN (0≤x, y, z≤1, x+y+z=1). As described above, if the nitride semiconductor crystal layer 14 includes Ga, the surface roughness of the nitride semiconductor crystal layer 14 is caused by means of a conventional technique because the elemental Ga is chemically reacted with the elemental Si of the silicon substrate 11. Therefore, the function/effect of the present invention can be exhibited at maximum when the nitride semiconductor crystal layer 14 includes Ga because the surface roughness through the chemical reaction can be prevented due to the AlN micro crystalline layer 13.

After the thick nitride semiconductor crystal layer 14 is formed, the nitride semiconductor crystal layer 14 may be peeled off from the silicon substrate 11 with the AlN micro crystalline layer 13. In this case, only the nitride semiconductor crystal layer 14 is applied for a predetermined purpose.

### Examples:

The present invention will be described concretely hereinafter.

### (Example 1)

A GaN single crystal layer was formed by means of an MOCVD method on the steps as shown in Figs. 1-4. Herein, the thickness tm of the mask was set to 100nm, and the length of each opening of the mask was set to 300 µm, and the distance between the adjacent openings, i.e., the pitch of the openings was set within 5-10 µm. The AIN micro crystalline layer 12 was formed in a thickness of 200nm by heating the silicon substrate to 1000°C by means of an MOCVE method. In this Example, the GaN single crystal layer was able to be thickened to a thickness of 1 µm or more during a growth period of 20 minutes. It was also confirmed by means of SEM observation that the surface of the GaN single crystal layer was extremely flat

### (Example 2)

A GaN single crystal layer was formed by means of an HVPE method on the steps as shown in Figs. 1-4. Herein, the same mask was employed as in Example 1, and an AlN micro crystalline layer 14 was formed in the same manner as in Example 1. In this Example, the GaN single crystal layer was able to be thickened to a thickness of about 40 µm at a substrate temperature of about 1000°C during a growth period of two hours. It was also confirmed by means of SEM observation that the surface of the GaN single crystal layer was extremely flat.

Although the present invention was described in detail with reference to the above examples, this invention is not limited to the above disclosure and every kind of variation and modification may be made without departing from the scope of the present invention.

## Claims

1. A method for producing a nitride semiconductor crystal layer, comprising the steps of:
preparing a silicon substrate,
forming an AlN micro crystalline layer in a thickness of 200nm or over on said silicon substrate, and
forming said nitride semiconductor crystal layer with a composition of InxGayAlzN (0≤x, y, z≤1, x+y+z=1) on said AlN micro crystalline layer.

2. The producing method as defined in claim 1, wherein a thickness of said AIN micro crystalline layer is set within 200-600nm.

3. The producing method as defined in claim 1 or 2, wherein said AlN micro crystalline layer is formed by heating said silicon substrate to a temperature within 900-1200°C by means of an MOCVD method.

4. The producing method as defined in any one of claims 1-3, wherein said AlN micro crystalline layer is formed on said silicon substrate through a lattice-shaped mask which is formed on said silicon substrate.

5. The producing method as defined in claim 4, wherein said mask includes rectangular openings.

6. The producing method as defined in claim 5, wherein a side length of each opening of said mask is set within 50-500 µm.

7. The producing method as defined in claim 5 or 6, wherein a distance between said openings adjacent to one another is set within 5-10 µm.

8. The producing method as defined in any one of claims 4-7, wherein a thickness of said mask is set to 100nm or below.

9. The producing method as defined in any one of claims 4-8, wherein said mask is made of at least one selected from silicon nitride, silicon dioxide and tungsten nitride.

10. The producing method as defined in any one of claims 1-9, wherein a thickness of said nitride semiconductor crystal layer is set to 5 µm or over.

11. The producing method as defined in claim 10, wherein said nitride semiconductor crystal layer is formed by means of an MOCVD method.

12. The producing method as defined in any one of claims 1-9, wherein a thickness of said nitride semiconductor crystal layer is set to 100 µm or over.

13. The producing method as defined in claim 12, wherein said nitride semiconductor crystal layer is formed by means of an HVPE method.

14. The producing method as defined in any one of claims 10-13, wherein said silicon substrate is shaped as a wafer, and a diameter of said silicon substrate is set to four inches or over.

15. The producing method as defined in any one of claims 1-14, wherein said nitride semiconductor crystal layer includes Ga.

16. A nitride semiconductor crystal layer comprising:
a composition of InxGayAlzN (0≤x, y, z≤1, x+y+z=1), and
a thickness of 5 µm or over,
wherein said nitride semiconductor crystal layer is formed on a silicon substrate.

17. The nitride semiconductor crystal layer as defined in claim 16, wherein said nitride semiconductor crystal layer is formed by means of an MOCVD method.

18. A nitride semiconductor crystal layer comprising:
a composition of InxGayAlzN (0≤x, y, z≤1, x+y+z=1), and
a thickness of 100 µm or over,
wherein said nitride semiconductor crystal layer is formed on a silicon substrate.

19. The nitride semiconductor crystal layer as defined in claim 18, wherein said nitride semiconductor crystal layer is formed by means of an HVPE method.

20. The nitride semiconductor crystal layer as defined in any one of claims 16-19, wherein said silicon substrate is shaped as a wafer, and a diameter of said silicon substrate is set to four inches or over.

21. The nitride semiconductor crystal layer as defined in any one of claims 16-20, wherein said nitride semiconductor crystal layer includes Ga.

22. A substrate for producing a nitride semiconductor crystal layer, comprising:
a silicon substrate, and
an AlN micro crystalline layer with a thickness of 200nm or over which is formed on said silicon substrate.

23. The substrate as defined in claim 22, wherein a thickness of said AlN micro crystalline layer is set within 200-600nm.

24. The substrate as defined in claim 22 or 23, wherein said AlN micro crystalline layer is formed by heating said silicon substrate at a temperature within 900-1200°C by means of an MOCVD method.

25. The substrate as defined in any one of claims 22-24, wherein said AlN micro crystalline layer is formed on said silicon substrate through a lattice-shaped mask which is formed on said silicon substrate.

26. The substrate as defined in claim 25, wherein said mask includes rectangular openings.

27. The substrate as defined in claim 26, wherein a side length of each opening of said mask is set within 50-500 µm.

28. The substrate as defined in claim 26 or 27, wherein a distance between said openings adjacent to one another is set within 5-10 µm.

29. The substrate as defined in any one of claims 25-28, wherein a thickness of said mask is set to 100nm or below.

30. The substrate as defined in any one of claims 25-29, wherein said mask is made of at least one selected from silicon nitride, silicon dioxide and tungsten nitride.
